# EUROPEAN PATENT APPLICATION

(11) **EP 0 993 030 A2**
(43) Date of publication of application: **12.04.2000**
(21) Application number: 99305928.6
(22) Date of filing: 26.07.1999
(51) Int. Cl.: H01L 21/306, H01L 21/308, H01L 21/8242

(54) **Integrated chip dummy trench patterns to ease trench etch process development**

(30) Priority: 13.08.1998 US 133425
(71) Applicant: International Business Machines Corporation, Armonk, NY 10504 (US); SIEMENS AKTIENGESELLSCHAFT, 80333 München (DE)
(72) Inventor: Alsmeier, Johann, IBM United Kingdom Ltd. I.P.L., Winchester, Hampshire SO21 2JN (GB); Bronner, Gary, IBM United Kingdom Ltd. I.P.L., Winchester, Hampshire SO21 2JN (GB); Kaplita, George A., IBM United Kingdom Ltd. I.P.L., Winchester, Hampshire SO21 2JN (GB); Kleinhenz, Richard, IBM United Kingdom Ltd. I.P.L., Winchester, Hampshire SO21 2JN (GB); Muller, Paul K., IBM United Kingdom Ltd. I.P.L., Winchester, Hampshire SO21 2JN (GB); Ranade, Rajiv M., IBM United Kingdom Ltd. I.P.L., Winchester, Hampshire SO21 2JN (GB); Roithner, Klaus, IBM United Kingdom Ltd. I.P.L., Winchester, Hampshire SO21 2JN (GB)
(74) Representative: Boyce, Conor

(57) **Abstract**

Dummy trenches are used in developmental trench layouts to address loading effects including micro-loading secondary loading. The use of dummy trenches in development enables the establishment of trench etching protocols in layouts that do not have the final design loading of device trenches, which protocols can be directly used in final chip formation without the need for re-engineering. Dummy trenches can also be used in the design of chips containing a combination of logic and DRAM layouts to address adverse loading effects and to permit use of a common DRAM trench layout for a variety of chips containing different logic layouts.

## Description

This invention relates generally to a method for creating deep trench shapes during the developmental stages of integrated circuit chip design and, more specifically, to a method for achieving the intended final chip silicon loading percentage for the deep trench etching process during developmental stages of chip design.

In the manufacture of integrated circuit chips, especially integrated circuit chips providing Dynamic Random Access Memory (DRAM) circuitry, deep trench capacitors are etched in a silicon substrate using a process known as selective Reactive Ion Etching (RIE). The sizes and shapes of the deep trenches are integral to the design of the chip, and are transferred from a circuit design layout to the chip through the use of a "hard mask," also known as a Deep Trench (DT) mask. This hard mask may be a silicon oxide mask deposited by Chemical Vapor Deposition (CVD) from tetra ethyl orthosilicate (TEOS), or created by other processes well known in the art.

The hard mask covers the areas of the chip that are not desired to be etched, thus allowing the RIE process to etch the substrate only in the areas where the hard mask is absent. Etching or erosion of the hard mask itself also occurs during the RIE process.

The population density of trenches on a chip is expressed as a silicon loading percentage or "loading," corresponding to the overall percentage of silicon surface open area that is removed by the trenches. The silicon etch rate is nearly independent of the silicon loading, so there is minimal "loading effect" of the type traditionally referred to in the art dealing with integrated circuit etch processes (see generally C. Mogab, J. Electochem. Soc. 124, 1263 (1977)). Nevertheless, other effects of deep trench etch processes, or "secondary loading effects" as detailed by K. Muller in "Selectivity and Silicon Load in Deep Trench Etching," Microelectronic Engineering 27, 457 (1995), are very load sensitive.

One such secondary loading effect impacts selectivity, defined as the ratio of the silicon etch rate to the mask erosion rate. During the etching process, oxygen introduced by the etching chemistry combines with the silicon-containing etch products to form a protective silicon oxide coating, or passivation film, that deposits on the wafer surface. This passivation film deposits on the side walls of the trenches and on the hard mask. Deposition of the film on the hard mask reduces mask erosion. Thus, lower silicon loads generally lead to higher mask erosion rates, because less silicon-containing etch products are available to form the passivation film.

Load-dependent etching effects and secondary etching effects can also be localized in areas of high silicon loading, creating so-called "micro-loading effects" and "secondary micro-loading effects." For instance, the mask erosion rate for a specific location is dependent upon the local silicon load in its neighborhood. Thus, a chip field at the center of the wafer surrounded by other exposed chip fields shows a smaller mask erosion rate than one at the edge of the wafer, where there are no other exposed chip fields further out. This condition is referred to as a secondary micro-loading effect.

As previously discussed, the passivation film formed from the combination of etching chemistry and etch products not only deposits on the surface of the wafer, but also on the trench side walls. The side wall deposition determines the trench taper angle, which is formed by the deposition of the side wall passivation film with increasing thickness over etch time. The trench taper angle strongly affects the capacitor surface area; the capacitance is determined in part by the exposed surface at the bottom of the trench. Thus, for trenches having a specified width at the wafer surface and a specified depth, a steep taper angle will provide a larger surface area, and thus more capacitance, at the bottom of the trench than will a more gradual taper angle.

On the other hand, tapered side walls are advantageous for achieving successful, void-free, and seam-free trench filling. Thus, the trench taper angle must be controlled to a fraction of a degree to assure proper capacitance surface area, yet enable void-free and seam-free polysilicon fill. Control of the taper angle is dependent on secondary loading effects, because the taper angle is formed by the deposition of the side wall passivation film with increasing thickness over etch time.

Given the above-described secondary loading and secondary micro-loading effects, and the importance of providing a consistent taper angle, control of the precise etching chemistry is necessary to maintain the hard mask (typically a silicon oxide) integrity and to consistently create properly dimensioned trenches during the etch process.

Typically, during the early development phase of a new DRAM chip, isolated portions of the chip are designed and manufactured for evaluation. For instance, successive design stages may progress from a first stage having a 3.2% silicon load to a second stage with a 6.2% silicon load to a third stage with 11.4% silicon load, compared with a 12.5% silicon load final design. Because of the secondary loading effects, the etching chemistry of the RIE process may have to be redesigned with each successive design phase to ensure proper trench formation without excessive mask erosion. Thus, the changes in loading factor result in time-consuming development of RIE chemistry applicable only to a specific design phase, never to be used again.

In addition, on early test chips, often several lithographic "ground rules" are present. These ground rules dictate the minimum-size resist images allowable. Trenches conforming to the smallest ground rules may inconsistently open during the etching process, so the loading factor may change from lot to lot or wafer to wafer by as much as 200%, creating a large variation in trench etch profile.

Also, an emerging technology is to port DRAM design blocks onto logic chips to create "embedded DRAM." Because the main portion of the resulting chip is logic, without deep trenches, the loading factor on those chips is much different from the chip from which the DRAM designs were lifted, necessitating re-development of the etching chemistry for those chips.

Finally, "black silicon," a phenomenon not yet fundamentally understood, may form when a specific feature to be etched has a large area, generally greater than 10 µm x 10 µm. Black silicon is characterized by dense deposits of grass-like spikes of silicon that have a detrimental impact on electrical reliability. Generally, these spikes form in a region where the etching process stops in a small area where the protective silicon oxide layer then develops, while the etching process continues in the surrounding area.

It is an object of the present invention to reduce or eliminate the need for etch chemistry redesign for every stage of chip development, by providing a method for determining a trench etching protocol (one or more etching process conditions) during chip development which protocol may be reused for trench etching in subsequent development stages and in final chip manufacture. It is a further object of this invention to provide a trench layout pattern containing dummy trench shapes of a size small enough to prevent formation of black silicon, large enough to consistently open, and distributed evenly throughout the chip to prevent localized secondary loading effects during trench etching.

In one aspect, the invention provides a method for laying out a pattern of deep trench shapes for a developmental integrated chip design that is not a final integrated chip design as claimed in claim 1.

The invention also encompasses methods of modifying chip designs wherein trench-based devices are incorporated onto chips wherein the layout of devices contains a substantial area occupied by devices (e.g. logic functions) that do not involve formation of deep trenches. In these methods, dummy trenches are strategically placed in the trench layout of the final chip design in order to achieve more consistent trench etch semiconductor material loading and to minimize micro-loading effects during trench etching in the final design.

The dummy trench shapes may be sized small enough to prevent "black silicon" formation and large enough to consistently open. The dummy trench shapes may also be distributed evenly to avoid micro-loading effects.

The invention further comprises a method of determining trench etching protocols using the layout method of the invention. The invention further comprises methods of forming trenches in a final chip design wherein a portion of the design includes trench features, the method using an etching protocol to etch trenches wherein the protocol is determined in trench development using a layout technique of the invention. The etching protocol determined according to the invention preferably includes one or more parameters selected from the group consisting of etching time, etching temperature, etchant composition, and bias voltage. The preferred semiconductor material is silicon.

Embodiments of the invention will now be described with reference to the accompanying drawings, in which:
Fig. 1 shows a portion of an integrated circuit chip with design trenches in the used area of the chip;
Fig. 2 shows the same portion of an integrated circuit chip as in Fig. 1, but with the addition of dummy trenches in the unused area of the chip; and
Fig. 3 shows a cross section of a silicon substrate undergoing the deep trench etching process.

The invention is illustrated with reference to the figures wherein similar numbers indicate the same elements in all figures. It is emphasized that, according to common practice, the various features of the drawings are not to scale. On the contrary, the dimensions of the various features are arbitrarily expanded or reduced for clarity.

The discussion below regarding layouts of devices generally refers to methods and information that are preferably embodied in electronic form. Thus, the information and calculations regarding layouts and silicon shapes discussed below are preferably embodied in a programmed electronic computing device which performs the calculations in accordance with the layout methods discussed below.

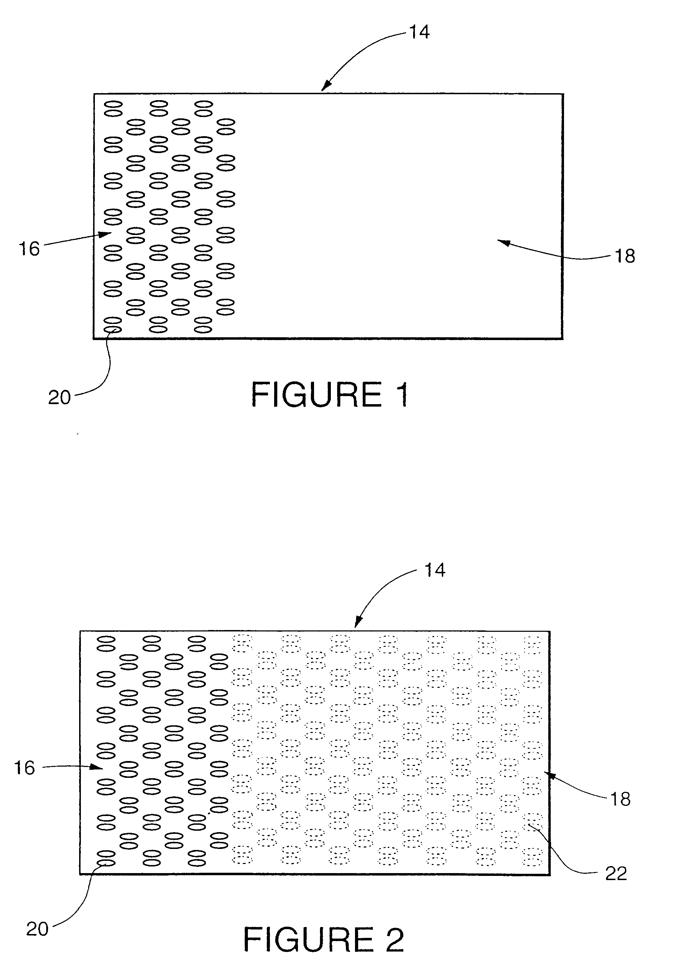

Fig. 1 shows a representative portion of an integrated circuit chip 14 having a used area 16 and an unused area 18, with design deep trenches 20 in the used area. The size of the device trenches may typically be 0.3 µm x 0.5 µm with an oval cross section. Assuming that the used area is 25% of the chip area, and that the design trench area is 12.5% of the used area, the overall chip silicon loading is thus 3.125%. Compared to an intended final design loading of 12.5% for the chip, the loading of figure 1 would be expected to require different etch chemistry than a chip of the final design. Furthermore, the loading of Fig. 1 would induce micro-loading and secondary micro-loading effects in used area 16 during the deep trench etching process.

Fig. 2 shows the same chip as Fig. 1, but now with dummy trenches 22 distributed evenly throughout the unused area 18. Assuming that the unused area is 75% of the total chip area, and the dummy trench area is 12.5% of the unused area, the overall chip loading is now 3.125% + 9.375% = 12.5%, the same as the intended final design loading.

Note that the same 12.5% loading target (i.e. equal to the final design loading at trench etching stage) could be met with a single large trench (not shown), but it is known that trenches having a dimension in excess of 10 µm x 10 µm might induce formation of black silicon. Although the current understanding of the minimum trench dimension at which black silicon forms is not exactly defined, it is known that any size below 10 µm x 10 µm is generally safe. Thus, in the preferred embodiment, dummy trenches are designed to be smaller than 10 µm x 10 µm. As the phenomenon becomes better understood, however, this maximum safe dimension could be enlarged. It is within the scope of the present invention to use dummy trenches of any size that will not induce formation of black silicon.

The 12.5% loading target could also be met with more numerous smaller trenches at the ground rule size (not shown), but this is also not a preferred embodiment. The ground rule is the minimum dimension of a trench that can be laid out with a particular masking system, as limited by the lithographic capabilities of the system. For example, a particular embodiment may have a ground rule of 0.25 µm. Trenches at the ground rule size may not open consistently, and thus introduce inconsistency in the repeatability of the etch results. It has been found that trench sizes at least about 1.2 times (more preferably about 1.2 - 1.4 times) the ground rule size consistently open and thus stabilize the total silicon load from run to run. Therefore, in the particular embodiment with a 0.25 µm ground rule, the smallest dummy trenches are preferably sized at about 0.3 µm x 0.5 µm, which is 1.2 times the ground rule.

The 12.5% loading target could also be met by grouping a large number of dummy trenches in one area of the chip and fewer in another area. In a preferred embodiment, however, the dummy trenches are evenly distributed over the entire chip field so that the overall layout of dummy and device trenches is an even distribution. This reduces any micro-loading effects as well as the more substantial secondary micro-loading effects.

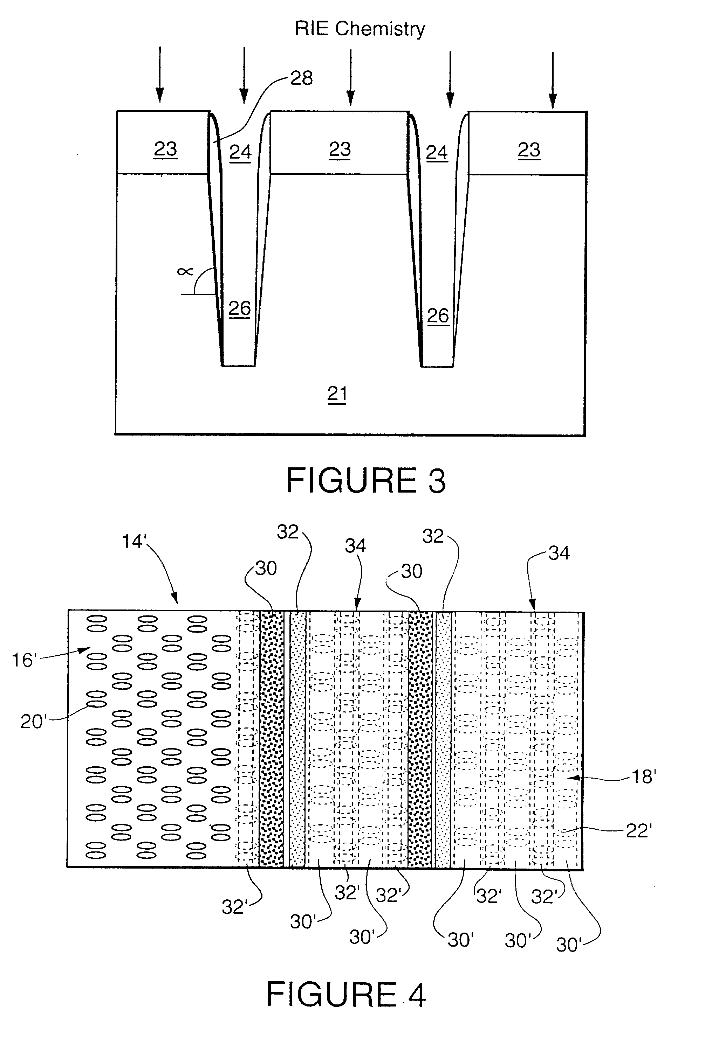

Fig. 3 shows a cross section of a chip undergoing the deep trench etching process. The chip consists of a substrate 21 having a hard mask 23 overlaid. Gaps 24 in the hard mask correspond to the areas where trenches are desired. Upon application of the RIE process, the etch chemicals etch the silicon, forming deep trenches 26 at the gaps 24 in the hard mask 23. In addition, oxygen in the etch chemistry reacts with silicon etched from the substrate and the hard mask, and forms a protective silicon dioxide deposit 28 on the trench walls. This deposit naturally forms a taper angle α with the trench side wall. This taper angle must be controlled to a fraction of a degree to assure proper capacitance surface area yet enable void-free and seam-free polysilicon fill. Because the amount of silicon dioxide deposit is governed by silicon load, the silicon load from dummy trenches and device trenches in chip development is preferably as close as possible to the silicon load of the final product to avoid a shift in trench taper angle during the migration from a development mask to a final product mask.

Thus, the method of the present invention for laying out deep trench shapes for a developmental integrated chip design is carried out by first estimating the final chip design silicon loading percentage. Next, the plurality of device deep trench shapes that make up the portion of the chip being developed are laid out. These trenches cumulatively have a device silicon loading percentage. The device silicon loading percentage is then subtracted from the estimated final chip design loading percentage to calculate the dummy silicon loading percentage, and the plurality of dummy deep trench shapes are laid out with a cumulative silicon loading percentage as calculated. The dummy trench shapes are sized small enough to avoid black silicon formation, but preferably at least about 1.2 times the ground rule size, and are distributed to provide preferably a substantially even distribution of device trenches and dummy trenches across the chip.

In addition the methods pertaining to stand-alone DRAM (or other trench-based) devices, the invention also encompasses methods which may also be used for incorporating DRAM devices in a logic chip in accordance with applied specific integrated circuit (ASIC) applications. ASIC applications with "embedded DRAM" are an emerging technology where deep trench DRAM designs are incorporated onto logic chips so that a DRAM function can be applied to specific applications on specific logic chips.

By embedding the DRAM on the same chip as the logic, ASIC technology increases the speed of a chip by enabling an increase in communication bandwidth between the memory and logic functions of a circuit. Since the logic function is the ASIC design feature that is typically varied depending on the end use, a generic DRAM design may be used with any number of specific ASIC logic designs to create individualized ASIC chips designed for specific applications. The present invention enables the formation of chips having different logic designs in combination with a generic DRAM design, wherein the same trench etch protocol can be developed and used for trench formation in each chip independent of the final logic design. Thus, the invention eliminates the need to develop a different etch chemistry for each new ASIC chip, assuming the size of DRAM desired and the overall size of the ASIC chip remain the same. Also, the invention can be used to avoid micro-loading problems associated with the segregation of the DRAM in a small portion of the overall chip.

An example of this embodiment of the invention is shown in Fig. 4. Fig. 4 shows an integrated circuit chip 14' that is a logic chip having an embedded DRAM circuit. The DRAM deep trenches 20' are located in used area 16'-- "used" with respect to DRAM. Unused area 18' is unused for DRAM. In the unused area 18', there is a logic circuit that generally may include components comprising functional active area shapes 30 and functional gate conductor shapes 32 as shown. Isolation areas 34 are typically located between functional logic circuit shapes. These isolation areas may comprise Shallow Trench Isolation (STI) between active areas in the active substrate layer, and gaps between gate conductors in the gate layer. To prevent dishing during the planarization steps for the active layer and the gate layer, dummy logic shapes such as dummy active area shapes 30' and dummy gate conductor shapes 32' may be located in the isolation areas between functional shapes 30 and 32.

According to the method of the invention, dummy trenches are placed in the logic design at the deep trench level. The dummy trenches preferably act to minimize silicon loading and micro-loading effects (I) by bringing the total silicon loading at trench etch up to a standard target loading, and by (ii) distributing the total silicon loading at trench etch over the chip surface. So that the dummy trenches do not interfere with the logic circuit, the dummy trenches are aligned with the isolation regions and/or dummy logic regions of the logic circuit. Referring to Fig. 4, dummy deep trenches 22' are placed under the dummy logic shapes in the isolation region 34 between functional logic devices. As there are often large isolation areas between functional shapes, this arrangement typically allows sufficient space to distribute the dummy trenches in the manner previously described to avoid micro-loading and secondary micro-loading effects. These dummy trenches 22' are also preferably sized to be at least about 1.2 (more preferably about 1.2 to 1.4) times the ground rule size to consistently open, yet sufficiently small to avoid black silicon formation.

By standardizing the silicon loading at the trench etch level, the method of the present invention enables a single DRAM design to be used for many different ASIC chips. Additionally, the invention provides the above-mentioned benefits associated with trench etching protocol development in ASIC chips as is achieved with conventional DRAM.

A development layout (or ASIC trench layout) determined according to the method of the invention may then be used to determine a trench etching protocol. This process generally involves forming a development hard mask based on the development layout using photolithography. An etching protocol for suitably etching trenches in the development layout is then determined using known procedures (e.g. using trial and error, visual inspection, etc.). In accordance with the invention, the development etching protocol can advantageously be used as the trench etching protocol of the final chip design even though trench level elements of the final design may have been absent from the development chip. Examples of trench etching protocols are disclosed in U.S. Patents 5,118,383 and 5,354,421. Additionally, the formation of the hard mask based on the design layout may be performed using techniques known in the art. For example, see the disclosure in "Fundamentals of Semiconductor Processing Technologies" by Badih El-Kareh, Kluwer Academic Publishers (1995).

## Claims

1. A method for laying out a pattern of deep trench shapes for a trench level of a developmental integrated chip design, the method comprising:
defining an estimated final chip design trench-level semiconductor material loading percentage;
laying out, as part of said pattern, a plurality of device deep trench shapes cumulatively having a device trench-level semiconductor material loading percentage; and
laying out, as part of said pattern, a plurality of dummy deep trench shapes cumulatively having a dummy trench-level semiconductor material loading percentage, wherein the dummy trench-level semiconductor material loading percentage is equal to the estimated final design trench-level semiconductor material loading percentage minus the device trench-level semiconductor material loading percentage.

2. The method according to claim 1, wherein said semiconductor material is silicon and said dummy trench shapes have dimensions which avoid black silicon formation in any subsequent etching.

3. The method according to claim 1 or 2 wherein at least one dimension of said dummy deep trench shapes is at least about 1.2 times larger than a minimum feature size limit for the trench level.

4. The method according to claim 3 wherein the dummy trenches are distributed to provide a substantially even distribution of trench-level semiconductor material loading across the chip.

5. The method according to claim 1 wherein the integrated chip design is for a dynamic random access memory device or for a dynamic random access memory device embedded on a logic chip.

6. A method of forming an integrated circuit chip from a semiconductor material substrate, said integrated circuit chip comprising deep trench-containing devices at a trench level, said method comprising:
(a) laying out a development pattern to be etched into a developmental semiconductor material substrate according to claim 1;
(b) transferring said development pattern to a surface of said developmental semiconductor material substrate,
(c) forming trenches in said substrate by etching said pattern to define a development trench etching protocol,
(d) defining a design pattern, said design pattern corresponding to a complete layout of trenches for all of said trench-level devices, said design pattern containing at least one trench shape which differs in at least one parameter selected from the group consisting of location, shape and size from all the trenches in said development pattern,
(e) transferring said design pattern to a surface of a final semiconductor material substrate, and
(f) forming trenches in said final substrate by etching said pattern using at least one parameter from said etching protocol.

7. The method of claim 6 wherein said parameter is selected from the group consisting of etching time, etching temperature, etchant composition, and bias voltage.

8. The method of claim 6 wherein said etching in steps (c) and (f) comprise reactive ion etching.

9. The method of claim 1 wherein information corresponding to said pattern is stored electronically and said layout shapes of dummy shapes is determined by a computer program using electronic input corresponding to said estimated final chip design trench-level semiconductor material loading percentage and electronic input corresponding to the part of said pattern formed by said device deep trench shapes.

10. A method of forming an integrated circuit chip from a semiconductor material substrate, said integrated circuit chip comprising (i) deep trench-containing devices at a trench level and (ii) at least one logic device in a logic device layout, said method comprising:
(a) laying out a pattern to be etched into said trench level of a semiconductor material substrate according to claim 1;
(b) transferring said pattern to a surface of said semiconductor material substrate,
(c) forming trenches in said substrate by etching said pattern, and
(d) forming said logic device in said logic device layout on said substrate.

11. The method of claim 10 wherein said logic device layout comprises non-functional features selected from the group consisting of dummy active areas, dummy gates, and shallow trench isolation.

12. The method of claim 11 wherein at least a portion of said dummy trenches are located on said trench level in positions directly below non-functional features of said logic device layout.

13. The method of claim 6 or 10 wherein said transferring of step (b) or (e) comprises forming a hard mask on said surface of said substrate.

14. The method of claim 10 wherein said etching of step (c) is performed using an etching protocol defined by etching different trench pattern in another substrate, said different trench pattern having at least one trench shape which differs in at least one parameter selected from the group consisting of location, shape and size from all the trenches etched in step (c), said different trench pattern having a layout of shapes substantially the same as the layout of deep trench device shapes of step (a) (ii).
